(19) Europäisches Patentamt
European Patent Office
Office européen des brevets

(11) **EP 3 208 922 A1**

(12) **EUROPÄISCHE PATENTANMELDUNG**

(43) Veröffentlichungstag:
**23.08.2017 Patentblatt 2017/34**

(21) Anmeldenummer: **16156306.9**

(22) Anmeldetag: **18.02.2016**

(51) Int Cl.:
*H02M 1/32* (2007.01)     *G01R 31/40* (2014.01)
*H02M 7/49* (2007.01)     *H02M 7/483* (2007.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Siemens Aktiengesellschaft**
**80333 München (DE)**

(72) Erfinder:
• **Blum, Manuel**
**85521 Ottobrunn (DE)**
• **Galek, Marek**
**82398 Polling (DE)**

(54) **MODULSELBSTDIAGNOSE IN EINEM MODULAREN MEHRZELLEN STROMRICHTER**

(57) Der Betrieb von modularen Stromrichtern soll sicherer gemacht werden. Dazu wird ein Verfahren zum Überprüfen eines modularen Stromrichters vorgeschlagen, der mehrere in Serie geschaltete Module aufweist, von denen jedes eine Halbbrücke mit zwei in Serie verbundenen Schaltern (S1 und S2) und einen zu der Halbbrücke parallelen Pufferkondensator (C) aufweist. Unmittelbar parallel zu dem Pufferkondensator (C) ist ein Spannungsmesser (V) in dem jeweiligen Modul angeordnet. Beim Schließen eines der beiden Schalter (S1, S2) wird ein Spannungsverlauf durch den Spannungsmesser (V) erfasst. Dieser Spannungsverlauf wird nach der Zeit differenziert, und daraus wird ein Überprüfungssignal erzeugt. Damit kann die Prüfung auf Modulebene erfolgen.

FIG 2

**Beschreibung**

Die vorliegende Erfindung betrifft ein Verfahren zum Überprüfen eines modularen Stromrichters, der mehrere in Serie geschaltete Module aufweist, von denen jedes eine Halbbrücke mit zwei in Serie verbundenen Schaltern und einen zu der Halbbrücke parallelen Pufferkondensator aufweist, wobei unmittelbar parallel zu einem der Schalter ein Spannungsmesser in dem jeweiligen Modul angeordnet ist. Darüber hinaus betrifft die vorliegende Erfindung einen modularen Stromrichter mit diesen mehreren Modulen sowie einer Steuerungseinrichtung.

Häufig werden elektronische Systeme modular ausgebaut. Der Grund hierfür kann in der Flexibilität, in der verarbeiteten Leistung, der eingesetzten Spannung etc. liegen.

Ein konkretes Beispiel für modulare Systeme sind sogenannte modulare Mehrpunktstromrichter (Modular Multilevel Converter: M2C). Solche modulare Mehrpunktstromrichter können beispielsweise für Hochspannungs-Gleichstrom-Übertragungen (HGÜ) eingesetzt werden. Sie eignen sich aber ebenso für Mittelspannungsanwendungen.

Der modulare Aufbau solcher Systeme bedingt, dass die einzelnen Module in geeigneter Weise angesteuert werden müssen. Dazu kann jedes Modul einzeln mit einem separaten Kabel angesprochen werden. Alternativ hierzu können die Module des Systems aber auch durch einen Kommunikationsbus vernetzt sein. Dieser Bus stellt dann die Schnittstelle zwischen einer zentralen Steuerungseinheit und den einzelnen Modulen dar. Dabei kann jedes Modul in Abhängigkeit von seiner Funktion beziehungsweise seines Aufbaus einen Aktor, eine Zelle oder dergleichen darstellen.

Durch die Modularisierung von Stromrichtern werden zahlreiche Vorteile erlangt. Ein besonderer Vorteil ist der einer redundanten Systemauslegung. So kann beispielsweise zu jedem Modul ein paralleles Modul vorgesehen sein. Fällt ein Modul dieses Modulpaars aus, so kann die Funktion durch das andere Modul des Modulpaars erfüllt werden. Das Defekte Modul wird abgeschaltet beziehungsweise überbrückt.

Durch diese Redundanz ist trotz des Ausfalls eines oder mehrerer Module das Aufrechterhalten des Betriebs möglich. Zur weiteren Erhöhung der Redundanz kann zudem jedes Modul aus mehreren, zu logischen Schaltern zusammengefassten parallelgeschalteten Halbleitern bestehen.

Eines von zahlreichen typischen Ausfallbildern ist der Verlust des Sperrvermögens eines der Halbleiterschalter, beispielsweise verursacht durch Alterung oder Überlast. Dieser Defekt führt bei Nichterkennen zu Brückenkurzschlüssen und somit zum Entladen der im Modul-Zwischenkreis gespeicherten Energie und zur Zerstörung beziehungsweise Beschädigung des gesamten Moduls.

In dem konkreten Anwendungsbeispiel eines M2C sind die Module bekanntermaßen in Reihe geschaltet. Um den Betrieb aufrecht zu erhalten, muss bislang das fehlerhafte Modul durch einen Bypassschalter überbrückt werden. Ein Weiterbetrieb des Gesamtsystems war also nicht ohne Weiteres möglich.

Die Aufgabe der vorliegenden Erfindung besteht somit darin, die Ausfallsicherheit eines Stromrichters zu verbessern. Es soll ein entsprechendes Verfahren und ein geeigneter Stromrichter bereitgestellt werden.

Erfindungsgemäß wird diese Aufgabe gelöst durch ein Verfahren zum Überprüfen eines modularen Stromrichters, der mehrere in Serie geschaltete Module aufweist, von denen jedes eine Halbbrücke mit zwei in Serie verbundenen Schaltern und einen zu der Halbbrücke parallelen Pufferkondensator aufweist, wobei unmittelbar parallel zu dem Pufferkondensator ein Spannungsmesser in dem jeweiligen Modul angeordnet ist, wobei das Verfahren die folgenden Schritte aufweist:

- Schließen eines der beiden Schalter,
- Erfassen eines Spannungsverlaufs durch den Spannungsmesser,
- Differenzieren des Spannungsverlaufs nach der Zeit und
- Erzeugen eines Überprüfungssignals direkt oder indirekt aus dem differenzierten Spannungsverlauf.

Darüber hinaus wird erfindungsgemäß bereitgestellt ein modularer Stromrichter mit

- mehreren in Serie geschaltete Modulen, von denen jedes

    o eine Halbbrücke mit zwei in Serie verbundenen Schaltern und
    o einen zu der Halbbrücke parallelen Pufferkondensator und
    o unmittelbar parallel zu dem Pufferkondensator ein Spannungsmesser aufweist, sowie

- einer Steuerungseinrichtung, wobei
- der Spannungsmesser jedes Moduls dazu ausgebildet ist, einen Spannungsverlauf während eines Schließens eines der beiden Schalter des Moduls zu erfassen,
- jedes Modul eine an den Spannungsmesser angeschlossene Signalverarbeitungseinrichtung zum Differenzieren des Spannungsverlaufs nach der Zeit und zum Erzeugen eines Überprüfungssignals direkt oder indirekt aus dem differenzierten Spannungsverlauf aufweist.

In vorteilhafter Weise wird also für die Überprüfung der einzelnen Zellen beziehungsweise Module des Stromrichters ausgenutzt, dass jedes der Module mit einem Spannungsmesser ausgestattet ist. Daher können bereits auf Modulebene Spannungen gemessen und Entscheidungen getroffen werden. Es ist nicht notwendig, die entsprechenden Messgrößen durch eigens vorgesehene Sensoren zu ermitteln und die Steuerung der Module in Abhängigkeit von diesen ermittelten Größen nur durch die zentrale Steuerungseinrichtung durchzuführen. In vorteilhafter Weise wird von einem Modul des Stromrichters, das eine Halbbrücke mit zwei Schaltern aufweist, der eine Schalter geschlossen. An dem Modul wird die Ausgangsspannung durch einen Spannungsmesser insbesondere während des Schließvorgangs beobachtet. Es ergibt sich ein entsprechender Spannungsverlauf, der nach der Zeit analog oder digital differenziert wird. Dieser differenzierte Spannungsverlauf zeigt das gleiche Verhalten wie der Stromverlauf des Moduls, da das Modul impedanzmäßig im Wesentlichen durch den Pufferkondensator bestimmt ist. Aus dem differenzierten Spannungsverlauf wird schließlich ein Überprüfungssignal direkt oder indirekt erzeugt. Ein solches Überprüfungssignal lässt sich modulintern oder -extern weiterverarbeiten. So kann es beispielsweise zur Steuerung der Schalter, aber auch als Eingangssignal für eine zentrale Steuerungseinrichtung dienen, welche wiederum selbst beispielsweise entsprechende Warnsignale ausgeben kann.

Vorzugsweise erfolgen die Verfahrensschritte des Schließens, des Erfassens, des Differenzierens und des Erzeugens vollständig in dem jeweiligen Modul. Dies bedeutet, dass die Überprüfung des Moduls durch dieses selbst erfolgen kann. Weite Kommunikationswege sind nicht erforderlich. Gegebenenfalls kann das Überprüfungssignal dann auch direkt zur eigenen Steuerung verwendet werden.

In einer Ausgestaltung wird das Überprüfungssignal indirekt aus dem differenzierten Spannungsverlauf erzeugt, indem ein Stromverlauf aus dem differenzierten Spannungsverlauf berechnet und daraus das Überprüfungssignal gewonnen wird. Aus dem gemessenen Spannungsverlauf wird also explizit der Stromverlauf berechnet, der für die Belastung der einzelnen Bauelemente verantwortlich ist. Durch diesen expliziten Stromverlauf lassen sich die Verhältnisse im Modul besser einschätzen und man ist nicht auf die weniger aussagekräftige Größe des differenzierten Spannungsverlaufs angewiesen.

In einer weiteren Ausgestaltung wird bei dem Erzeugen des Überprüfungssignals der differenzierte Spannungsverlauf oder der Stromverlauf mit einem vorgegebenen Schwellwert verglichen. Liegt dann beispielsweise der Strom zu einem gewissen Zeitpunkt über einem vorgegebenen Schwellwert, so kann von einer Gefährdung der Bauelemente und insbesondere der Schalter beziehungsweise Leistungsschalter ausgegangen werden. Das Ergebnis dieses Vergleiches kann dann dazu genutzt werden, um das Modul beispielsweise abzuschalten beziehungsweise zu überbrücken.

Bei einer Weiterentwicklung erhalten die beiden Schalter eines der Module von der Steuerungseinrichtung jeweils einen Befehl zum Wechsel des Schaltzustands, und das Überprüfungssignal wird für diesen Wechsel erzeugt. Gerade bei dieser Topologie des Moduls, bei der ein Pufferkondensator an- und abgeschaltet wird, können massive Stromspitzen und Kurzschlussströme entstehen. Daher ist es von besonderem Vorteil, wenn das Modul gerade bei dem Schalten überprüft wird und gegebenenfalls eine entsprechende Plausibilitätsprüfung erfolgt. Bei dem modularen Stromrichter bestehen die typischen Schaltvorgänge dann darin, den Pufferkondensator in die Modulkette zu schalten, oder ihn aus der Kette herauszunehmen. Dementsprechend wird der eine Schalter der Halbbrücke, zu der der Pufferkondensator parallel liegt, ausgeschaltet und der andere Schalter eingeschaltet, oder umgekehrt. Gerade bei einem solchen Wechsel sollte im Fehlerfall rasch reagiert und das defekte Modul abgeschaltet werden.

Speziell kann so einer der beiden Schalter von der Steuerungseinrichtung einen Befehl zum Ausschalten und der andere Schalter einen Befehl zum Einschalten bekommen, und wenn der differenzierte Spannungsverlauf oder der Stromverlauf bei einem korrespondierenden Schaltvorgang über einen vorgegebenen Wert steigt, kann mit dem Überprüfungssignal signalisiert werden, dass der zum Ausschalten angesteuerte Schalter defekt ist. Es kann somit aus der Logik, welcher Schalter eingeschaltet und welcher Schalter ausgeschaltet wird, darauf geschlossen werden, welcher von ihnen im Fall des Überschreitens des Schwellwerts defekt ist. Konkret ist nämlich davon auszugehen, dass sich bei der Schaltung ein Kurzschluss ergibt, wenn beide Schalter eingeschaltet sind, das heißt einer der beiden Schalter nicht dem Ausschaltsignal folgt.

In einer weiteren Ausgestaltung kann sich das Modul relativ zu den anderen selbst in einen Überbrückungszustand schalten, wenn der Defekt signalisiert wird. Dies bedeutet, wie oben bereits angedeutet wurde, dass das Überwachungssignal intern im Modul genutzt wird, um die eigenen Bauelemente und insbesondere die Schalter zu steuern. Dabei ist es zweckmäßig, wenn das Modul ausgeschaltet beziehungsweise überbrückt wird, wenn von ihm ein Defekt erkannt beziehungsweise signalisiert wird.

Ein Überbrücken eines Moduls kann vorteilhafterweise dadurch erreicht werden, dass derjenige der beiden Schalter geöffnet wird, der nicht unmittelbar parallel an den Spannungsmesser angeschlossen ist, wobei der andere der beiden Schalter gegebenenfalls geschlossen wird. Dies bedeutet, dass der Strompfad zum Pufferkondensator durch den geöffneten Schalter unterbrochen ist und der geschlossene Schalter die Eingangsklemmen des Moduls kurzschließt.

Mindestens einer der Schalter des Moduls oder jedes Moduls kann mehrere parallele Einzelschalter aufweist, und alle Einzelschalter des jeweiligen Moduls können gegebenenfalls im defekten Pfad für den Überbrückungszustand zum Einschalten angesteuert werden. Gegebenenfalls werden von einem Modul sämtliche Highside-Einzelschalter zum Öffnen und die Lowside-Einzelschalter zum Schließen angesteuert.

Die oben im Zusammenhang mit dem erfindungsgemäßen Verfahren geschilderten Verfahrensmerkmale können auch als funktionelle Merkmale des erfindungsgemäßen modularen Stromrichters gesehen werden. Dann kommt die jeweilige Funktion dem zugehörigen Element des Stromrichters zu.

Die vorliegende Erfindung wird nun anhand der beigefügten Zeichnungen näher erläutert, in denen zeigen:

FIG 1    die Architektur eines modularen Mehrpunktstromrichters; und

FIG 2    den prinzipiellen Schaltplan eines Moduls mit zwei Schaltern.

Die nachfolgend näher geschilderten Ausführungsbeispiele stellen bevorzugte Ausführungsformen der vorliegenden Erfindung dar. Dabei ist zu beachten, dass die einzelnen Merkmale nicht nur in den geschilderten Kombinationen, sondern auch in Alleinstellung oder in anderen technisch sinnvollen Kombinationen realisierbar sind.

Ein verteiltes, modulares, elektronisches System weist eine Vielzahl von Modulen und mindestens eine Steuereinheit auf. Die Module sind über einen oder mehrere Kommunikationsbusse mit einer zentralen Steuereinheit verbunden. Derartige verteilte Systeme können im Anlagenbau zahlreiche Anwendungen finden. Dabei kann jedes Modul einen Aktor (z.B. einen Leistungsschalter) aufweisen, der eine elektrische Funktionalität besitzt.

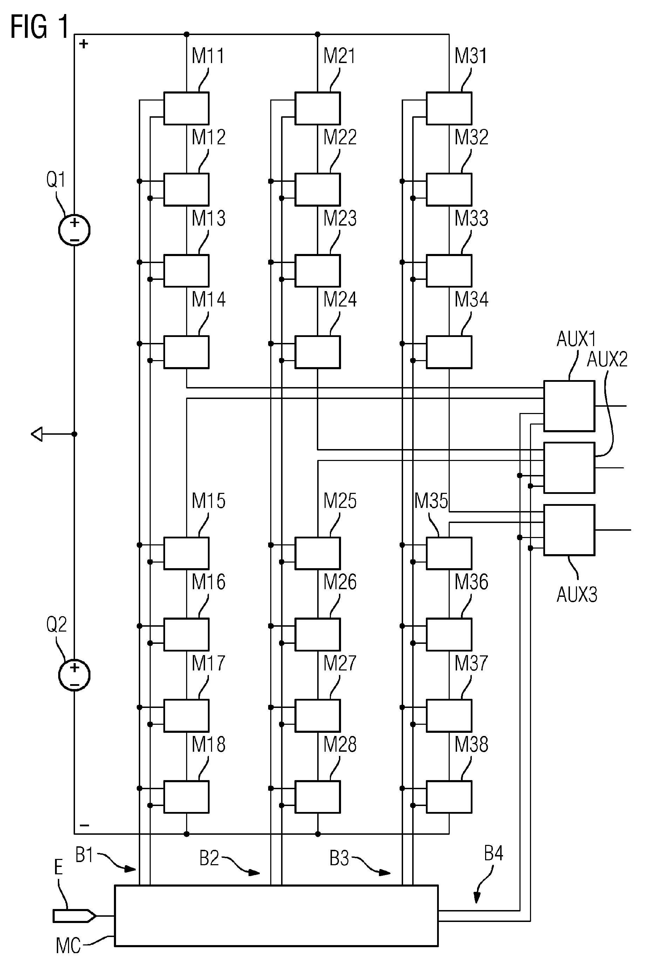

In dem Beispiel von FIG 1 ist ein modulares System dargestellt, welches als modularer Mehrpunktstromrichter realisiert ist. Ein solcher Stromrichter dient beispielsweise zum Gleichrichten eines Drehstroms in einem Gleichstrom, wie es beispielsweise für HGÜ-Übertragungen notwendig ist. Der dargestellte Stromrichter kann aber auch am anderen Ende der HGÜ-Leitung zum Wandeln von Gleichstrom in Drehstrom eingesetzt werden. Das Systemkonzept der modularen Mehrpunktstromrichter ist aber auch für Umrichter verwendbar.

Der in FIG 1 wiedergegebene Mehrpunktstromrichter besitzt eine Vielzahl an Modulen, die strangweise miteinander verknüpft sind. In einem ersten Strang befinden sich die Module M11 bis M18, in einem zweiten Strang die Module M21 bis M28 und in einem dritten Strang die Module M31 bis M38. Alle Module besitzen in der Regel gleichen Aufbau. Jeweils vier der Module in einem Strang sind bezogen auf ihren Leistungspfad in Serie geschaltet.

Zwei Gleichspannungsquellen Q1 und Q2 sind im vorliegenden Beispiel in Serie geschaltet, und durch diese Serienschaltung wird eine Plusschiene "+" und eine Minusschiene "-" symmetrisch mit Gleichspannung gespeist.

Die drei Modulserienschaltungen M11 bis M14, M21 bis M24 und M31 bis M34 sind einerseits an die Plusschiene angeschlossen und andererseits mit einer jeweiligen Hilfseinheit AUX1, AUX2 und AUX3 verbunden. Symmetrisch dazu sind die Modulserienschaltungen M15 bis M18, M25 bis M28 und M35 bis M38 einerseits mit der Minusschiene verbunden und andererseits mit den Hilfseinheiten AUX1, AUX2 und AUX3. Konkret führen also die Leistungspfade der Module M14 und M15 in die Hilfseinheit AUX1, die Leistungspfade der Module M24 und M25 in die Hilfseinheit AUX2 und die Leistungspfade der Module M34 und M35 in die Hilfseinheit AUX3. Jede der Hilfseinheiten AUX1, AUX2 und AUX 3 vereint die jeweiligen Leistungspfade und produziert eine Phase eines Drehstromsystems. Damit wäre ein Wechselrichter realisiert.

Alternativ kann der Stromrichter, wie oben erwähnt, auch dazu ausgebildet sein, dass er in umgekehrter Richtung einen dreiphasigen Strom in einen Gleichstrom wandelt. In diesem Fall kann er als Gleichrichter genutzt werden.

Die Steuerung des Stromrichters erfolgt mit einer Steuereinheit MC. Diese Steuereinheit MC steuert hier nicht nur sämtliche Module, sondern auch die Hilfseinheiten AUX1, AUX2 und AUX3. Mit einem ersten Bus B1 werden die Module M11 bis M18, mit einem zweiten Bus B2 die Module M21 bis M28, mit einem dritten Bus B3 die Module M31 bis M38 und mit einem vierten Bus B4 die Hilfseinheiten AUX1 bis AUX3 gesteuert. Jeder dieser Busse B1 bis B4 verfügt nicht nur über mindestens eine Datenleitung, sondern auch über mindestens eine Hilfsspannungsleitung. Über die jeweilige Datenleitung werden gegebenenfalls bidirektional Daten transportiert. Ebenfalls werden die einzelnen Module von der Steuereinheit MC mit Steuerdaten versorgt. Gegebenenfalls werden Zustandsdaten wie etwa Spannungen, Temperaturwerte und dergleichen, zurück an die Steuereinheit MC geliefert.

Über die Hilfsspannungsleitungen der Busse B1 bis B4 werden sowohl die Module als auch die Hilfseinheiten von der Steuereinheit MC mit einer Hilfsspannung versorgt, die die jeweiligen aktiven Bauelemente für den Betrieb brauchen. Die Steuereinheit MC besitzt gegebenenfalls noch einen Eingang E für externe Befehle.

Der Stromrichter von FIG 1 ist rein exemplarisch. Der prinzipielle Aufbau könnte auch für einen einphasigen Stromrichter oder einen anderen mehrphasigen Stromrichter genutzt werden. Auch muss an den Zwischenkreis nicht eine symmetrische Spannung vorliegen, sodass jeder Strang nicht symmetrisch zweigeteilt sein muss wie in dem Beispiel von FIG 1. In diesem Fall können dann auch gegebenenfalls die Hilfseinheiten AUX1 bis AUX3 entfallen. Auch die Anzahl der Module pro Strang kann variieren.

Bei bekannten modularen Stromrichtern sind üblicherweise nur die Hilfseinrichtungen AUX1, AUX2 und AUX3, die die drei Phasen liefern, mit Strommessern ausgestattet. Es können damit nur Ströme in den einzelnen Strängen gemessen und an die zentrale Steuerungseinrichtung MC gemeldet werden. Dadurch kann nicht der Strom jedes einzelnen Moduls gemessen werden und darüber hinaus ergeben sich lange Kommunikationswege. Dem hilft die vorliegende Erfindung ab, indem in jedem Modul der jeweilige Strom zumindest indirekt gemessen wird.

Systembedingt ist nämlich auf jedem Modul eine Spannungsmessung der Zell- beziehungsweise Modulspannung vorzusehen. Diese Spannungsinformation kann auf Modulebene ausgewertet werden. Da die zeitliche Änderung der Spannung im direkten Zusammenhang mit dem den Zwischenkreis der Zelle ladenden beziehungsweise entladenden Strom steht, ist es durch Differentiation der Spannung möglich, auf den durch den Pufferkondensator des Moduls fließenden Strom zu schließen.

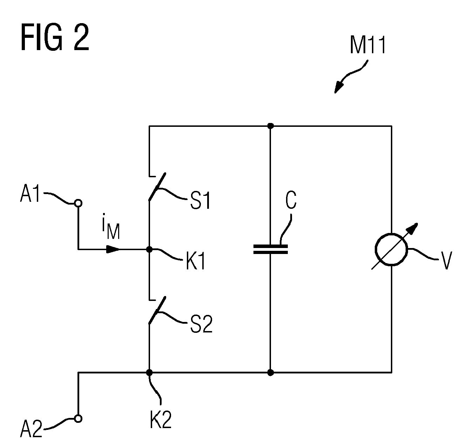

Dies kann durch FIG 2 besser verdeutlicht werden. Stellvertretend für ein Modul des Stromrichters sei hier das Modul M11 dargestellt. Es weist eine Halbbrücke mit zwei Schaltern S1 und S2 auf. Die beiden Schalter sind über einen Knoten K1 miteinander verbunden. Parallel zu der Serienschaltung der beiden Schalter S1 und S2 ist ein Pufferkondensator C geschaltet. Der dem Knoten K1 abgewandte Anschluss des Schalters S2 ist mit einem zweiten Knoten K2 verbunden.

Der Knoten K1 führt zu einem Modulanschluss A1 und der Knoten K2 zu einem Modulanschluss A2. Über diese Anschlüsse A1 und A2 ist das Modul M11, wie auch jedes andere Modul, leistungsmäßig in den Stromrichter geschaltet. Kommunikationsleitungen sind in FIG 2 der Übersicht halber nicht eingezeichnet. Ein Spannungsmesser V misst die Modulspannung zwischen den Modulanschlüssen A1 und A2. Der Spannungsmesser V ist modulintern und liefert seinen Spannungsmesswert beziehungsweise einen entsprechenden zeitlichen Spannungsverlauf an eine in FIG 2 nicht eingezeichnete Signalverarbeitungseinrichtung. Diese Signalverarbeitungseinrichtung ist in der Lage, einen Spannungsverlauf gerade während eines Schließvorgangs des Schalters S1 und/oder des Schalters S2 zu erfassen. Gegebenenfalls wird ein entsprechend aufgezeichneter Spannungsverlauf unmittelbar mit dem Schließvorgang synchronisiert.

Die Signalverarbeitungseinrichtung ist in der Lage, den Spannungsverlauf nach der Zeit zu differenzieren. Diese zeitliche Ableitung multipliziert mit der Größe des Pufferkondensators ergibt den zu überwachenden Strom $i_M$ in Abhängigkeit von der Zeit, wie er in das Modul M11 hineinfließt oder aus ihm herausfließt. Die entsprechende Formel lautet:

$$i_M = C \frac{dU}{dt}$$

In einem konkreten Beispiel kann der Schalter S1 als Highside-Schalter und der Schalter S2 als Lowside-Schalter bezeichnet werden. Die beiden Schalter werden entweder durch die externe Steuerungseinrichtung MC oder durch die modulinterne Steuerungseinrichtung geschaltet. Die Schalter S1 und S2 sind üblicherweise als Leistungsschalter ausgelegt. Die Schalter können jeweils auch mehreren parallel geschalteten Einzelschaltern bestehen. Beispielsweise kann es sich um IGBTs handeln.

Bei hoher Belastung oder durch Alterung kann es zu Beschädigungen der Schalter S1 und S2 kommen. Eine solche Beschädigung führt beispielsweise dazu, dass der jeweilige Schalter nicht mehr geöffnet werden kann.

Während des normalen Stromrichterbetriebs werden die Schalter S1 und S2 typischerweise abwechselnd ein- und ausgeschaltet. Bei einem Schaltvorgang wird beispielsweise der Highside-Schalter S1 geschlossen und der Lowside-Schalter S2 geöffnet. Dadurch befindet sich der Pufferkondensator C an den Modulanschlüssen A1 und A2. Der Spannungsmesser V misst die über den Pufferkondensator C abfallende Spannung.

Bei einem anschließenden Schaltvorgang wird der Highside-Schalter S1 geöffnet und der Lowside-Schalter S2 geschlossen. Dadurch ist der Pufferkondensator C beziehungsweise das gesamte Modul M11 überbrückt. Der Spannungsmesser V misst die Zellspannung.

Im Fehlerfall lässt sich beispielsweise der Lowside-Schalter S2 nicht mehr öffnen. Wird nun der Highside-Schalter S1 geschlossen, so wird der Pufferkondensator C kurzgeschlossen, da ja der Lowside-Schalter S2 immer noch geschlossen ist. Dieser Kurzschluss führt zu einer raschen Entladung des Pufferkondensators C, sodass die Ableitung des Spannungsverlaufs und damit der Strom durch die Schalter S1 und S2 kurzfristig sehr hoch sind. Gegebenenfalls addiert sich auf diesen Kurzschlussstrom im Schalter S2 noch der normale Betriebsstrom, der in das Modul M11 fließt.

Bei hinreichend hoher Abtastrate ist es auch möglich, einen solchen durch Brückenkurzschlüsse auftretenden Stoßstrom zu detektieren. So kann unter Umständen vermieden werden, dass weitere Bauelemente des Moduls, insbesondere die Leistungsschalter, beschädigt werden, indem der noch intakte Schalter umgehend geöffnet wird.

Durch Auswertung der letzten und der aktuellen Schalterstellungen kann bei auftretendem Stoßstrom auf den nicht mehr sperrfähigen Halbleiterschalter geschlossen werden. Steigt nämlich der Strom bei einem Schalterwechsel von Lowside-ON zu Highside-ON, so deutet dies auf einen Fehler im Lowside-Zweig hin. Steigt hingegen der Strom bei dem Schalterwechsel von Highside-ON zu Lowside-ON, so deutet dies auf einen Fehler im Highside-Zweig hin.

Ist durch die Signalverarbeitungseinrichtung des Moduls ein derartiger Fehler festgestellt, so kann nach dem Erkennen des Fehlers der normale Betrieb des Moduls unterbrochen werden. Hierzu kann beispielsweise bei Ausfall eines Lowside-Schalters der Highside-Schalter dauerhaft gesperrt werden. Besitzt das Modul mehrere Highside-Schalter und Lowside-Schalter, so können bei Ausfall eines der Lowside-Schalter alle Highside-Schalter dauerhaft gesperrt und die übrigen Lowside-Schalter eingeschaltet werden, sodass das Modul gebrückt wird.

Bei Ausfall eines Highside-Schalters kann durch geeignete Ansteuerung die Zwischenkreisspannung des Moduls kontrolliert zu 0 gefahren werden. Anschließend kann ebenfalls eine Brückung des Moduls mithilfe der Lowside-Schalter erfolgen. In vorteilhafter Weise nutzt die Erfindung die verteilte Steuerung eines modularen Stromrichters und insbesondere die modulinterne Spannungsmessung zur Überwachung beziehungsweise Plausibilitätsprüfung der Module. Durch die Anwendung der angegebenen Maßnahmen kann der Fehler beziehungsweise seine Auswirkung auf das Gesamtsystem minimiert werden. Somit kann ein Ausfall der gesamten Anlage verhindert werden und gerade bei kostenoptimierten Systemen kann eine gewisse Mindestredundanz ohne zusätzlichen Hardwareaufwand gewährleistet werden.

**Patentansprüche**

1. Verfahren zum Überprüfen eines modularen Stromrichters, der mehrere in Serie geschaltete Module aufweist, von denen jedes eine Halbbrücke mit zwei in Serie verbundenen Schaltern und einen zu der Halbbrücke parallelen Pufferkondensator aufweist, wobei unmittelbar parallel zu dem Pufferkondensator ein Spannungsmesser in dem jeweiligen Modul angeordnet ist, **gekennzeichnet durch**

   - Schließen eines der beiden Schalter,
   - Erfassen eines Spannungsverlaufs **durch** den Spannungsmesser,
   - Differenzieren des Spannungsverlaufs nach der Zeit und
   - Erzeugen eines Überprüfungssignals direkt oder indirekt aus dem differenzierten Spannungsverlauf.

2. Verfahren nach Anspruch 1, wobei die Verfahrensschritte des Schließens, des Erfassens, des Differenzierens und des Erzeugens vollständig in dem jeweiligen Modul erfolgen.

3. Verfahren nach Anspruch 1 oder 2, das Überprüfungssignal indirekt aus dem differenzierten Spannungsverlauf erzeugt wird, indem ein Stromverlauf aus dem differenzierten Spannungsverlauf berechnet und daraus das Überprüfungssignal gewonnen wird.

4. Verfahren nach einem der vorhergehenden Ansprüche, wobei bei dem Erzeugen des Überprüfungssignals der differenzierte Spannungsverlauf oder der Stromverlauf mit einem vorgegebenen Schwellwert verglichen wird.

5. Verfahren nach einem der vorhergehenden Ansprüche, wobei die beiden Schalter eines der Module von der Steuerungseinrichtung jeweils einen Befehl zum Wechsel des Schaltzustands erhalten und das Überprüfungssignal für diesen Wechsel erzeugt wird.

6. Verfahren nach Anspruch 5, wobei einer der beiden Schalter von der Steuerungseinrichtung einen Befehl zum Ausschalten und der andere Schalter einen Befehl zum Einschalten bekommt und, wenn der differenzierte Spannungsverlauf oder der Stromverlauf bei einem korrespondierenden Schaltvorgang über einen vorgegebenen Wert steigt, mit dem Überprüfungssignal signalisiert wird, dass der zum Ausschalten angesteuerte Schalter defekt ist.

7. Verfahren nach Anspruch 6, wobei sich das Modul relativ zu den anderen Modulen selbst in einen Überbrückungszustand schaltet, wenn der Defekt signalisiert wird.

8. Verfahren nach Anspruch 7, wobei derjenige der beiden Schalter geöffnet wird, der nicht unmittelbar parallel an den Spannungsmesser angeschlossen ist, und der andere der beiden Schalter gegebenenfalls geschlossen wird.

9. Verfahren nach Anspruch 7, wobei einer der Schalter des Moduls mehrere parallele Einzelschalter aufweist, und alle Einzelschalter für den Überbrückungszustand zum Einschalten angesteuert werden.

10. Modularer Stromrichter mit

   - mehreren in Serie geschaltete Modulen, von denen jedes

      o eine Halbbrücke mit zwei in Serie verbundenen Schaltern und
      o einen zu der Halbbrücke parallelen Pufferkondensator und
      o unmittelbar parallel zu dem Pufferkondensator ein Spannungsmesser aufweist, sowie

   - einer Steuerungseinrichtung,

   **dadurch gekennzeichnet, dass**

   - der Spannungsmesser jedes Moduls dazu ausgebildet ist, einen Spannungsverlauf während eines Schließens eines der beiden Schalter des Moduls zu erfassen,

- jedes Modul eine an den Spannungsmesser angeschlossene Signalverarbeitungseinrichtung zum Differenzieren des Spannungsverlaufs nach der Zeit und zum Erzeugen eines Überprüfungssignals direkt oder indirekt aus dem differenzierten Spannungsverlauf aufweist.

# FIG 1

FIG 2

Europäisches
Patentamt

European
Patent Office

Office européen
des brevets

**EUROPÄISCHER RECHERCHENBERICHT**

Nummer der Anmeldung

EP 16 15 6306

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2015/161893 A1 (SIEMENS AG [DE]) 29. Oktober 2015 (2015-10-29) * Abbildungen 1-4 * * Seite 1 - Seite 16 * ----- | 1-10 | INV. H02M1/32 G01R31/40 |
| X | DE 103 33 798 A1 (SIEMENS AG [DE]) 24. Februar 2005 (2005-02-24) * Zusammenfassung; Abbildungen 1-4 * * Absätze [0028] - [0038] * ----- | 1-10 | ADD. H02M7/49 H02M7/483 |
| X | DE 103 23 220 A1 (SIEMENS AG [DE]) 23. Dezember 2004 (2004-12-23) * Zusammenfassung; Abbildungen 1-4 * * Absätze [0036], [0037] * ----- | 1-7,10 | |
| A | HAGHNAZARI SAEED ET AL: "A new fault detection method for modular multilevel converter semiconductor power switches", IECON 2015 - 41ST ANNUAL CONFERENCE OF THE IEEE INDUSTRIAL ELECTRONICS SOCIETY, IEEE, 9. November 2015 (2015-11-09), Seiten 50-55, XP032855246, DOI: 10.1109/IECON.2015.7392075 [gefunden am 2016-01-25] * Abbildungen 1, 2, 5; Tabellen I, II * ----- | 1-10 | |
| A | JP 2015 130743 A (HITACHI LTD) 16. Juli 2015 (2015-07-16) * Abbildungen 1-4 * ----- | 1-10 | RECHERCHIERTE SACHGEBIETE (IPC) H02M G01R |

Der vorliegende Recherchenbericht wurde für alle Patentansprüche erstellt

| Recherchenort | Abschlußdatum der Recherche | Prüfer |
|---|---|---|
| Den Haag | 12. August 2016 | Kail, Maximilian |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 16 15 6306

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-08-2016

| Im Recherchenbericht angeführtes Patentdokument | Datum der Veröffentlichung | Mitglied(er) der Patentfamilie | | Datum der Veröffentlichung |
|---|---|---|---|---|
| WO 2015161893 A1 | 29-10-2015 | KEINE | | |
| DE 10333798 A1 | 24-02-2005 | DE | 10333798 A1 | 24-02-2005 |
| | | FR | 2858132 A1 | 28-01-2005 |
| DE 10323220 A1 | 23-12-2004 | KEINE | | |
| JP 2015130743 A | 16-07-2015 | KEINE | | |

EPO FORM P0461

Für nähere Einzelheiten zu diesem Anhang : siehe Amtsblatt des Europäischen Patentamts, Nr.12/82